# EUROPEAN PATENT APPLICATION

(11) **EP 4 336 728 A1**
(43) Date of publication of application: **13.03.2024**
(21) Application number: 23190793.2
(22) Date of filing: 10.08.2023
(51) Int. Cl.: H03F 3/217, H03M 3/04, H03F 1/34, H03F 3/187

(54) **AUDIO AMPLIFICATION METHOD AND DEVICE**

(30) Priority: 09.09.2022 IT 202200018453
(71) Applicant: STMicroelectronics S.r.l., 20864 Agrate Brianza (MB) (IT)
(72) Inventor: BOTTI, Edoardo, I-29029 Vigevano (Pavia) (IT); STILGENBAUER, Francesco, I-20017 Rho (Milano) (IT); MALCOVATI, Piero, I-27100 Pavia (IT); BONIZZONI, Edoardo, I-27100 Pavia (IT); DE FERRARI, Matteo, I-28040 Oleggio Castello (Novara) (IT)
(74) Representative: Campogiani, Giovanna

(57) **Abstract**

A method, comprising: receiving a digital audio input signal (D); applying signal processing (12, 14, 56, 17) to the digital audio input signal (D) received and providing an analog audio output signal (V_{OUT}) based on the digital audio input signal (D) via a switching converter circuit (17) driven by a pulse-width-modulated, PWM, signal (DRV); sensing (19, R_{FB}) the analog audio output signal (V_{OUT}) and providing an analog feedback signal (I_{FB}) indicative of the sensed analog audio output signal (V_{OUT}); wherein applying signal processing (12, 14, 56, 17) to the digital audio input signal (D) comprises: applying digital-to-analog conversion, DAC (12) to the digital audio input signal (D), producing an analog replica of the digital input signal (I_{IN}) as a result; producing (14) an analog error signal (I_{E}) indicative of a difference between the analog replica of the digital input signal (I_{IN}) and the analog feedback signal (I_{FB}); applying analog-to-digital conversion, ADC (560) to the analog error signal (I_{E}), producing a digital error signal (W) as a result; applying digital filtering (562) to the digital error signal (W), producing a filtered digital error signal (D_{C}) as a result; and driving the switching converter circuit (17) with the PWM signal (DRV) produced based on the filtered digital error signal (Dc).

## Description

### Technical field

The description relates to amplification of audio signals (audio amplification).

One or more embodiments may be applied to power amplifiers configured to operate on digital audio signals.

So-called class D audio amplifiers are exemplary of such power amplifiers.

### Description of the related art

Thanks to reduced costs of digital signal processing, digital audio signals are becoming common even in the realm of power amplifiers, whose output is inherently of an analog nature in order to drive audio speakers.

Therefore, such power amplifier technologies may comprise a mix of digital and analog components, with noise and distortion performance playing an important role for demanding applications.

Developing power amplifier structures suitable for processing digital input signals is also of interest with the aim of further improve performance at a lower cost.

### Object and summary

An object of one or more embodiments is to contribute in providing such improved solutions.

According to one or more embodiments, that object can be achieved via a method having the features set forth in the claims that follow.

One or more embodiments may relate to a corresponding device.

An audio power amplifier may be exemplary of such a device.

The claims are an integral part of the technical teaching provided herein with reference to the embodiments.

One or more embodiments facilitate reducing the chip size of a power amplifier with a digital input.

One or more embodiments increase the role of digital parts of the circuit with respect to analog blocks.

One or more embodiments facilitate dispensing with critical and complex circuit blocks.

### Brief description of the several views of the drawings

One or more embodiments will now be described, by way of non-limiting example only, with reference to the annexed Figures, wherein:
Figure 1 is a diagram of an analog portion of an audio amplifier,
Figure 2 is a diagram of a digital portion of an audio amplifier,
Figure 3 is a diagram of a digital audio amplifier,
Figure 4 is a diagram of a mixed digital and analog audio amplifier,
Figure 5 is a diagram of a solution as per the present disclosure,
Figure 6 is a diagram exemplary of a portion of the diagram of Figure 5,
Figure 6A is a diagram exemplary of a portion of the diagram of Figure 6,
Figure 7 is a diagram exemplary of a portion of the diagram of Figure 6,
Figure 7A is a diagram exemplary of an alternative arrangement for the portion of the diagram of Figure 6 exemplified in Figure 7,
Figure 8 is a diagram exemplary of a characteristic curve of the arrangement exemplified in Figure 7,
Figure 9 is a diagram exemplary of a characteristic curve of the arrangement exemplified in Figure 7A,
Figure 10 is a plot of the behavior in frequency of the arrangements exemplified in Figures 7 and 7A,
Figure 11 is a diagram of an alternative solution as per the present disclosure, and
Figure 12 is a time diagram comparing an evolution over time of signals in various embodiments.

Corresponding numerals and symbols in the different figures generally refer to corresponding parts unless otherwise indicated.

The figures are drawn to clearly illustrate the relevant aspects of the embodiments and are not necessarily drawn to scale.

The edges of features drawn in the figures do not necessarily indicate the termination of the extent of the feature.

### Detailed description

In the ensuing description, one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment.

Moreover, particular conformations, structures, or characteristics may be combined in any adequate way in one or more embodiments.

The drawings are in simplified form and are not to precise scale.

Throughout the figures annexed herein, like parts or elements are indicated with like references/numerals unless the context indicates otherwise, and for brevity a corresponding description will not be repeated for each and every figure.

The references used herein are provided merely for convenience and hence do not define the extent of protection or the scope of the embodiments.

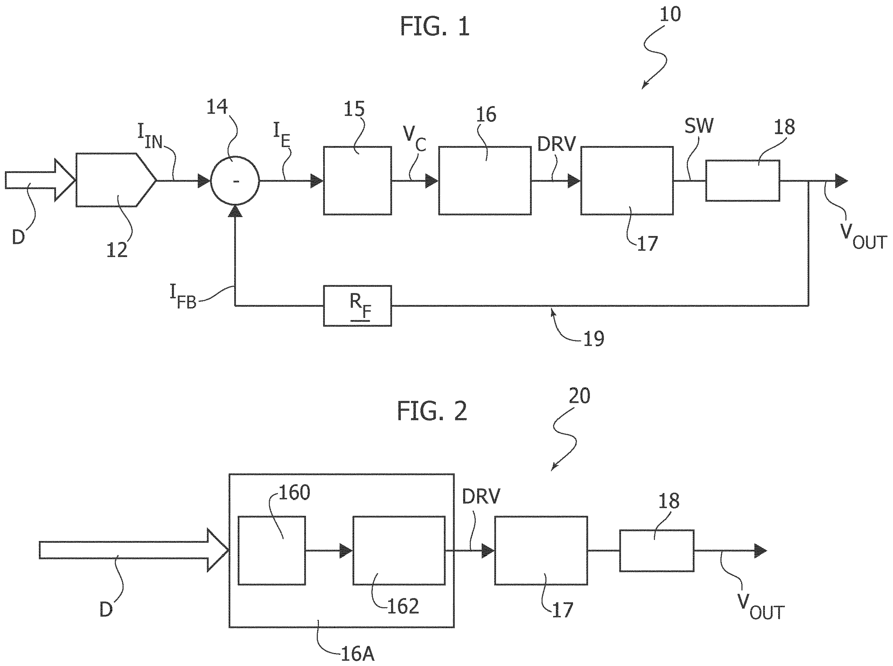

As exemplified in Figure 1, a signal processing chain 10 a conventional audio amplifier configured to receive a digital input signal D comprises:
an input node D configured to receive the digital input signal D,
an output node V_{OUT} configured to provide an output signal V_{OUT} configured to drive the audio speaker to reproduce an audio signal,
a digital-to-analog converter (briefly, DAC) circuit 12 coupled to the input node D to receive the digital signal D therefrom, the DAC circuit 12 configured to apply digital-to-analog conversion to the digital signal D, providing an analog signal I_{IN} as a result (such as an electrical current signal I_{IN}, for instance),
a summation node 14 coupled to the DAC circuit 12 and to the output node V_{OUT} (e.g., via a feedback branch 19, comprising a feedback resistive element R_{FB} to provide a feedback current signal I_{FB} as a ratio of the output signal V_{OUT} and a feedback resistance R_{FB} of the feedback resistive element, for instance I_{FB}=V_{OUT}/R_{FB}), the summation node 14 configured to produce an error signal I_{E} as a difference between the analog signal I_{IN} and the feedback current signal I_{FB},
an analog loop filter circuit 15 coupled to the summation node 14 to receive the error signal I_{E} therefrom, the analog loop filter 15 configured to produce a control signal V_{C} based on the error signal I_{E},
a pulse-width modulator (briefly, PWM) circuit 16 coupled to analog loop filter circuit 15 to receive the control signal Vc therefrom, the PWM circuit 16 configured to produce at least one drive signal DRV (in a manner per se known) based on the control signal Vc,
power circuitry 17 coupled to the PWM circuit 16 to receive the at least one drive signal DRV therefrom, the power circuitry 17 comprising at least one switching transistor configured to provide a switching voltage signal at a switching node SW based on the at least one drive signal DRV, in a manner per se known,
an inductor-capacitor network LC, e.g., comprising an inductor L in series with a capacitor C referred to ground, coupled to the switching node SW of the power circuitry 17 and configured to provide the output (e.g., voltage) signal V_{OUT} at the output node V_{OUT}.

As exemplified herein, the method comprises providing the output signal to at least one audio speaker 18 and driving the at least one audio speaker to reproduce the audio signal received at the input node.

As exemplified herein, the audio amplifier is coupled to at least one audio speaker 18 to provide thereto the output signal V_{OUT}, the audio amplifier configured to drive the at least one audio speaker to reproduce the audio signal received at the input node.

As exemplified in Figure 2, an alternative 20 to the conventional arrangement 10 exemplified in Figure 1 comprises an input node D coupled to a modified PWM circuit block 16A, the modified PWM circuit block 16A comprising:
a PWM (or pulse-density modulation, PDM, known per se) circuit block 160 configured to receive the digital input signal D from the input node D and to apply PWM or PDM processing 160 thereto, and
a low-pass filter 162, such as a feedforward THD correction circuit per se known, configured to filter the signal processed by the PWM/PDM circuit block 160, the low-pass filter 162 configured to provide the at least one drive signal DRV to the power stage 17 coupled to the inductor-capacitor network LC 18.

While the solution exemplified in Figure 2 may reduce the analog elements present in the signal processing chain, such an arrangement 20 is hardly compatible with high quality requirements. For instance, the absence of the feedback branch 19 leads to amplification of harmonic distortions, which may substantially affect the audio quality.

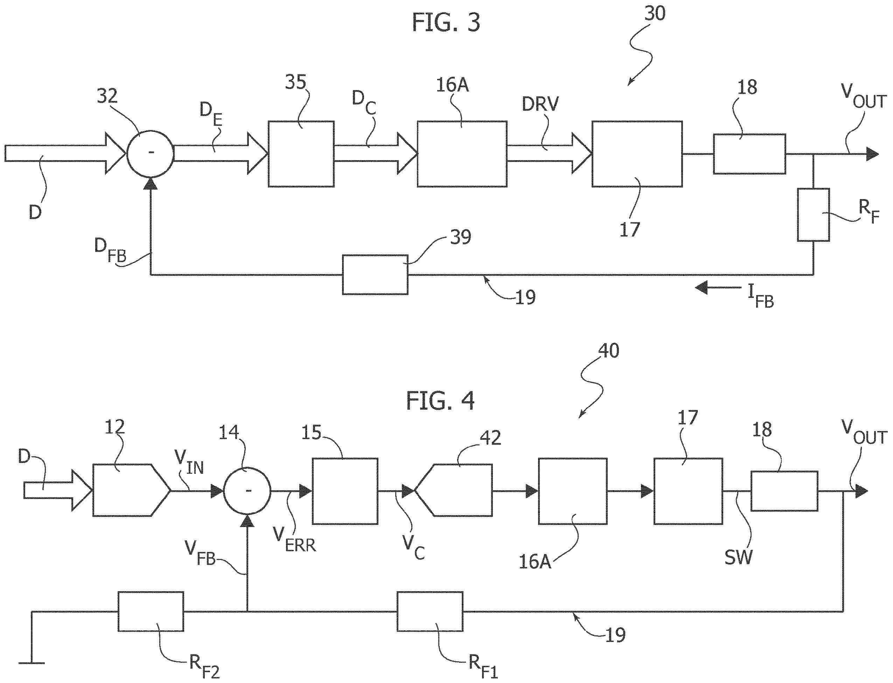

Figure 3 exemplified a further alternative arrangement 30 to the arrangement 10 exemplified in Figure 1.

As exemplified in Figure 3, the arrangement 30 comprises:
an input node D configured to receive a digital signal D,
an output node V_{OUT} configured to provide an output signal V_{OUT} in order to drive speakers to reproduce an audio signal,
a feedback branch 19 comprising the resistive feedback element RF configured to operate as discussed with respect to Figure 1 and an analog-to-digital converter (briefly, ADC) circuit 39 coupled to the feedback element to receive the feedback signal I_{FB} therefrom, the ADC circuit 39 configured to apply analog-to-digital conversion to the feedback signal I_{FB}, providing a digital feedback signal D_{FB} as a result,
a digital summation node 32 coupled to input node D and coupled to the output node V_{OUT} via the feedback branch 19, the digital summation node 32 configured to receive the digital input signal D and the digital feedback signal D_{FB} and to provide a digital error signal D_{E} indicative of a difference between the digital input signal D and the digital feedback signal D_{FB},
a digital loop filter circuit 35 coupled to the digital summation node 32 to receive the digital error signal D_{E}, the digital loop filter circuit 35 configured to provide a digital control signal D_{C} to the modified PWM stage 16A, where the modified PWM stage 16A operates as discussed with respect to Figure 2 and is coupled to the power circuitry 17 having a switching node SW coupled to the inductor-capacitor network 18 to provide the output (e.g., voltage) signal V_{OUT}.

A solution as exemplified in Figure 3 facilitates reducing the number of analog components; as a drawback, the performance of the arrangement 30 (e.g., in terms of total harmonic distortion - THD, dynamic range, signal-to-noise ratio - SNR, and so on) heavily relies on the performance of the main analog component, that is the ADC circuit 39 along the feedback branch 19. As a result, the arrangement 30 may hardly provide performances in the range of those provided by the conventional arrangement 10 of Figure 1, which can provide a dynamic range up to 120 dB and a THD lower than 0.02%.

As exemplified in Figure 4, a further alternative signal processing chain 40 for a conventional audio amplifier configured to receive a digital input signal D comprises:
an input node D configured to receive the digital input signal D,
an output node V_{OUT} configured to provide an output signal V_{OUT} configured to drive the audio speaker to reproduce an audio signal,
a digital-to-analog converter (briefly, DAC) circuit 12 coupled to the input node D to receive the digital signal D therefrom, the DAC circuit 12 configured to apply digital-to-analog conversion to the digital signal D, providing an analog signal I_{IN} as a result (such as an electric voltage signal V_{IN}, for instance),
a summation node 14 coupled to the DAC circuit 12 and to the output node V_{OUT} (e.g., via a feedback branch 19, comprising a feedback resistive divider R_{F1}, R_{F2} to provide a feedback signal V_{FB} as a fraction of the output signal V_{OUT}, for instance V_{FB}=V_{OUT}^{∗}R_{F2}/(R_{F1}+R_{F2}), the summation node 14 configured to produce an error signal V_{E} as a difference between the analog signal V_{IN} and the feedback signal V_{FB},
an analog loop filter circuit 15 coupled to the summation node 14 to receive the error signal V_{E} therefrom, the analog loop filter 15 configured to produce a control signal Vc based on the error signal V_{E},
an analog-to-digital converter (briefly, ADC) circuit 42 coupled to the analog loop filter to receive the control signal Vc therefrom, the ADC circuit 42 configured to apply analog-to-digital conversion to the control signal VC, providing a digital control signal as a result,
a modified PWM stage 16A coupled to the ADC circuit 42 to receive the digital control signal therefrom, where the modified PWM stage 16A operates as discussed with respect to Figure 2 and is coupled to the power circuitry 17 having a switching node SW coupled to the inductor-capacitor network 18 to provide the output (e.g., voltage) signal V_{OUT}.

The arrangement 40 exemplified in Figure 4 differs from the arrangement 30 exemplified in Figure 3 substantially in that the ADC circuit 42 is moved from the feedback branch (where it is indicated by reference number 39 in Figure 3) to the direct signal processing chain. As a result, the design constraints for such an ADC circuit block may be relaxed without affecting the whole performance of the system.

This may be the result of the fact that noise (and consequent distortion) introduced in the "direct" processing chain may be attenuated by a factor proportional to the closed gain loop before they reach the output node V_{OUT}.

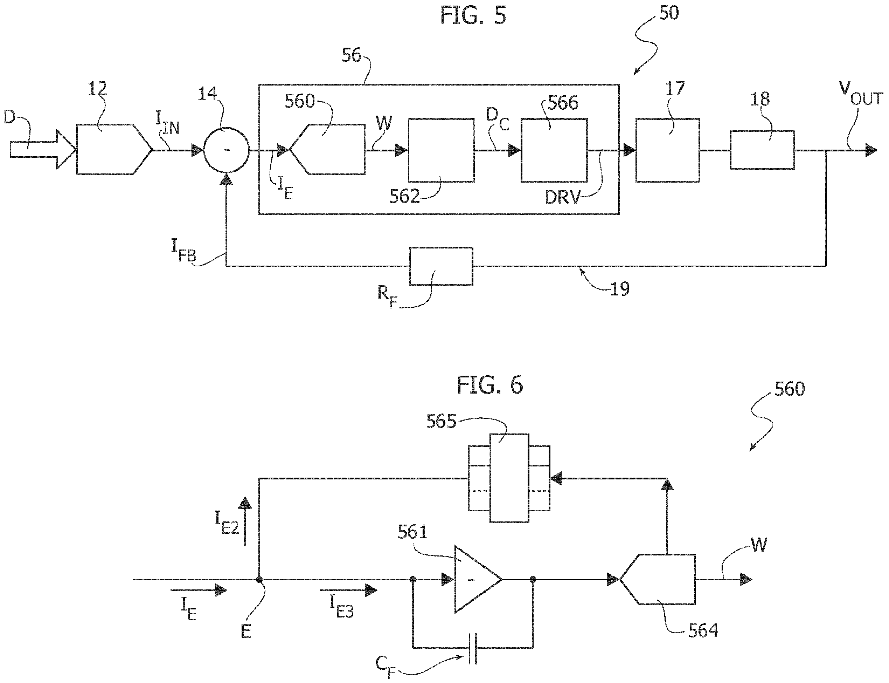

As exemplified in Figure 5, an arrangement 50 for a power stage of an audio amplifier according to the present disclosure, comprises:
an input node D configured to receive the digital input signal D,
an output node V_{OUT} configured to provide an output signal V_{OUT} configured to drive the audio speaker to reproduce an audio signal,
a digital-to-analog converter (briefly, DAC) circuit 12 coupled to the input node D to receive the digital signal D therefrom, the DAC circuit 12 configured to apply digital-to-analog conversion to the digital signal D, providing an analog signal I_{IN} as a result (such as an electric current signal I_{IN}, for instance),
a summation node 14 coupled to the DAC circuit 12 and to the output node V_{OUT} (e.g., via a feedback branch 19, comprising the feedback resistive element R_{FB} to provide the feedback signal I_{FB}, as discussed in the foregoing), the summation node 14 configured to produce an error signal I_{E} as a difference between the analog signal I_{IN} and the feedback signal I_{FB},
an enhanced signal processing chain 56 coupled to the summation node 14 to receive the error signal I_{E} and coupled to the power circuitry 17 having a switching node SW coupled to the inductor-capacitor network 18 to provide the output (e.g., voltage) signal V_{OUT}, the enhanced signal processing chain 56 configured to provide the at least one drive signal DRV to the power stage 17, the at least one driver signal being based on the error signal I_{E}.

As exemplified herein, a method comprises:
receiving a digital input audio signal D,
applying signal processing 12, 14, 56, 17 to the digital input audio signal received and providing an analog output audio signal V_{OUT} based on the digital input audio signal via a switching converter circuit 17 driven by a pulse-width-modulated, PWM, signal DRV,
sensing 19, R_{FB} the analog output audio signal and providing an analog feedback signal I_{FB} indicative of the sensed analog output audio signal.

For instance, applying signal processing to the digital input audio signal comprises:
applying digital-to-analog conversion, DAC 12 to the digital input audio signal, producing an analog replica of the digital input signal I_{IN} as a result;
producing 14 an analog error signal I_{E} indicative of a difference between the analog replica of the digital input signal and the analog feedback signal;
applying analog-to-digital conversion, ADC 560 to the analog error signal, producing a digital error signal W as a result;
applying digital filtering 562 to the digital error signal, producing a filtered digital error signal Dc as a result; and
driving the switching converter circuit with the PWM signal produced based on the filtered digital error signal.

As exemplified herein, an audio amplifier comprises:
a digital input node configured to receive a digital (audio) input signal D;
a signal processing chain 12, 14, 56, 17 coupled to the digital input node to receive the digital input audio signal, the signal processing chain configured to provide an analog output audio signal V_{OUT} based on the digital input audio signal via a switching converter circuit 17 driven by a pulse-width-modulated, PWM, signal DRV;
a sensing circuit branch 19, R_{FB} coupled to the output node to sense the analog audio output signal and configured to provide an analog feedback signal indicative of the sensed analog audio output signal.

For instance, the signal processing chain comprises:
a digital-to-analog, DAC converter circuit 12 configured to apply digital-to-analog, DAC conversion to the digital input audio signal, producing an analog replica of the digital input signal I_{IN} as a result;
a superposition node 14 coupled to the sensing circuit branch to receive the analog feedback signal and coupled to the DAC converter circuit to receive the analog replica of the digital input signal, the superposition node configured to produce an analog error signal I_{E} indicative of a difference between the analog replica of the digital input signal and the analog feedback signal;
an analog-to-digital converter, ADC circuit 560 coupled to the superposition node to receive the analog error signal I_{E} therefrom and configured to apply analog-to-digital conversion, ADC to the analog error signal, producing a digital error signal W as a result;
a digital filter circuit 562 coupled to the ADC circuit to receive the digital error signal and configured to apply digital filtering to the digital error signal, producing a filtered digital error signal Dc as a result, and
a pulse-width-modulated, PWM, generator circuit 566 coupled to the digital filter circuit to receive the filtered digital error signal, the PWM generator circuit configured to drive the switching converter circuit with the PWM signal produced based on the filtered digital error signal.

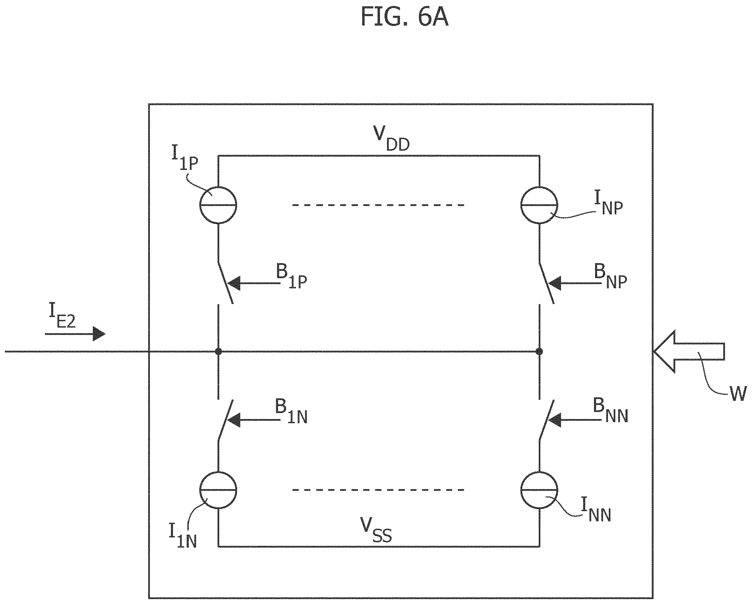

As exemplified in Figure 6, the enhanced signal processing chain 56 comprises:
a transresistance ADC circuit 560, comprising an analog-to-digital converter configured to receive a current signal and to convert it into a digital word signal W (or digital error signal W), the transresistance ADC circuit 560 coupled to the summation node 14 to receive the error current signal I_{E} therefrom, providing the digital word signal W as a result of applying analog-to-digital conversion thereto,
a digital (e.g., loop) filter circuit 562, known per se, coupled to the transresistance ADC circuit 560 to receive the digital word signal W therefrom, the digital filter circuit 562 configured to provide a digital control signal Dc based on the received digital word signal W,
a digital PWM stage 566 coupled to the digital filter circuit 562, the digital PWM stage 566 configured to provide the at least one control signal DRV to the power stage 17 based on the received digital control signal 16.

The arrangement exemplified in Figure 5 with respect to the arrangement exemplified in Figure 4 widens the digital domain and relaxes the design constraints on the ADC circuit without compromising accuracy, for instance thanks to the attenuation effect (already discussed in the foregoing) when using the ADC in the direct signal processing chain rather than in the feedback branch.

As exemplified in Figure 6, the transresistance ADC 560 comprises a sigma-delta modulator, comprising:
an input node E configured to receive the error current signal I_{E} from the summation node 14,
an integrator stage 561, CF comprising an (e.g., operational) amplifier 561 configured to receive the error signal at an (e.g., inverting) input node and having a capacitive element C_{F} interposed the amplifier input node and output node, the integrator stage 561, CF configured to provide an integrated signal indicative of an integral over time of the error current signal I_{E},
an array 565, such as a weighed current generator array or a resistive array, coupled to the input node I and configured to provide a feedback current I_{E2} based on a (e.g., thermometric) digital code received,
a (e.g., Flash Type) ADC 564 coupled to the integrator stage 561, C_{F} to receive the error current I_{E3} therefrom, the ADC 564 based on the principle of comparing analog input voltage with a set of reference voltages; to convert the analog input voltage into a digital signal of n-bit output, (2ⁿ - 1) comparators are involved, producing a digital word W as a result and providing the digital word to the array 565 to drive operation thereof.

For the sake of simplicity, the integrator stage 561 exemplified in Figure 6 comprises a single pole. It is noted that such an arrangement is purely exemplary and in no way limiting, as the integrator stage 561 may comprise also a higher number of poles.

As exemplified in Figure 6, the array 565 is configured to generate the feedback current I_{E2} having an intensity as close as possible to the input current intensity I_{E}. For instance, the feedback current I_{E2} may be expressed as: I_{E2} = I_{E} - I_{E3}, where I_{E2} is the current input to the integrator stage 561.

As exemplified herein:
the analog output signal comprises an output voltage signal;
the analog feedback signal indicative of the sensed analog voltage signal comprises a feedback current signal I_{FB} obtained as a ratio of the sensed analog voltage signal and a feedback resistive element R_{FB};
applying digital-to-analog, DAC conversion to the digital input signal comprises converting the digital input signal to an analog input current signal I_{IN};
the analog error signal indicative of the difference between the analog input current signal and the feedback current signal comprises an error current signal;
the method comprises applying transresistance analog-to-digital, ADC conversion to the error current signal I_{E}, producing the digital error signal as a result.

As exemplified herei, applying transresistance ADC conversion to the error current signal comprises applying sigma-delta processing to the error current signal, comprising:
subtracting a second error current signal I_{E2} from the error signal;
integrating 561 the error current signal, producing an integrated version of the error current signal;
applying flash ADC conversion 564; 564' to the integrated version of the error current signal, producing a digital word W comprising a plurality of bits B₁, B₂, B₇ as a result, and
generating 565 the second current signal as a function of the digital word.

As exemplified herein:
the analog output signal at the output node comprises an output voltage signal;
the analog feedback signal indicative of the sensed analog voltage signal comprises a feedback current signal obtained as a ratio of the sensed analog voltage signal and a feedback resistive element;
the digital-to-analog converter circuit is configured to apply digital-to-analog conversion to the digital input signal, converting the digital input signal to an input current signal I_{IN};
the analog error signal indicative of the difference between the input current signal and the feedback signal comprises an error current signal I_{E}; and
the ADC circuit is configured to apply transresistance analog-to-digital conversion to the error current signal, producing the digital error signal as a result.

As exemplified herein, the ADC circuit configured to apply transresistance analog-to-digital conversion to the error current signal comprises sigma-delta processing circuitry, comprising:
a subtracting node E coupled to the superposition node to receive the error signal, the subtracting node configured to subtract a second error current signal I_{E2} from the error signal;
an integrator circuit 561 coupled to the subtracting node, the integrator circuit configured to integrate the error current signal, producing an integrated version of the error current signal;
a flash ADC converter coupled to the integrator circuit to receive the integrated version of the error current signal, the flash ADC converter configured to apply flash ADC conversion to the integrated version of the error current signal, producing a digital word W comprising a plurality of bits B₁, B₂, B₇ as a result.

As exemplified herein, the gain of the integrator 561, CF may be set to a maximum value within stability constraints in order to reduce the current I_{E3}, thereby increasing the performance of the ADC converter. For instance, the integrator 561 may comprise a variable gain amplifier, e.g., having a number of poles higher than one and a gain that may be increased in the range of frequencies of interest.

Still in order to be able to control the performance of the transresistance ADC 560, it may be possible to vary, for instance:
the sampling frequency of the sigma-delta modulator, and/or
the number of bits of the flash ADC 564.

In the scenario exemplified in Figure 6, the precision of the sigma-delta modulator is also based on the DAC converting array 565 in the feedback branch.

As exemplified in Figure 6A, in order to improve the precision of the arrangement of Figure 6, the array 565 comprises a thermometric generator, optionally comprising a way of "scrambling" internal cells in order to reduce the impact of any mismatches therebetween.

As exemplified in Figure 6A, the array 565 comprises:
a plurality of current generators I_{1P}, I_{NP}, I_{1N}, I_{NN} configured to provide respective electrical currents (e.g., a same fraction of a total current I_{E2}) along a plurality of current lines between a positive supply line V_{DD} and a negative supply line Vss; and
a plurality of switches B_{1P}, B_{NP}, B_{1N}, B_{NN} comprising switches matched to respective current generators in the plurality of current generators I_{1P}, I_{NP}, I_{1N}, I_{NN}, the plurality of switches B_{1P}, B_{NP}, B_{1N}, B_{NN} configured to each receive a bit of the digital word signal W provided by the flash ADC 564 and to be made conductive in response to the respective bit received having a first (e.g., "1" or "true") value and to be made non-conductive in response to the respective bit received having a second (e.g., "0" or "false") value.

An arrangement as the one discussed in document US 7239258 B2 may be adapted for use in one or more embodiments.

For instance, in order to obtain an audio amplifier having an input dynamic range about 120 dB, the ADC circuit 564 exemplified in Figure 6 may be designed to provide the same dynamic range.

Using an arrangement as the one exemplified in Figure 5, a dynamic range of about 100 dB may suffice for the ADC 560 used therein.

As exemplified in Figure 5, the ADC 560 receives as input signal the error signal, so that with an adequate gain for the loop filter, the precision error may be maintained rather low, save for the initial bits of the digital word W. For the latter bits it may be possible to use clipping to increase precision, as discussed in the following.

Specifically, it is possible to vary the resolution of the flash ADC 564 so that it has higher resolution values in a first range of input voltage values and lower resolution values for a second range of input voltage values, the second range of values higher than the first range of values. As a result it may be possible to even the performance of the ADC on the full dynamic range of input values without increasing area or power consumption.

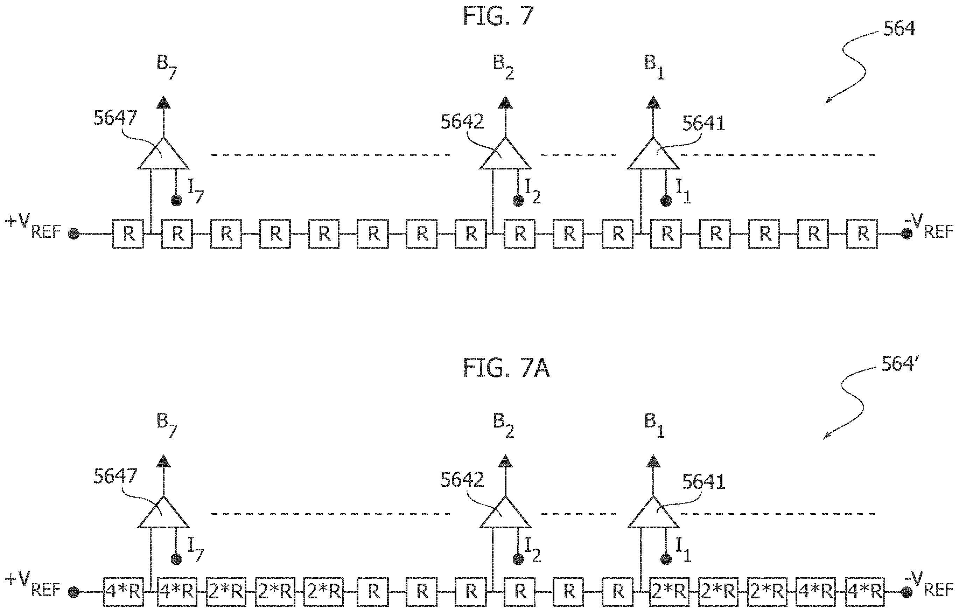

Figure 7 is exemplary of a possible implementation scenario of the flash ADC 564 that uses a "uniform" resolution, while Figure 7A is exemplary of an alternative implementation scenario in which an alternative flash ADC 564' uses a skewed resolution, as discussed in the foregoing.

For the sake of simplicity, the examples in Figures 7 and 7A both relate to a flash ADC with four bits (corresponding to fifteen current levels), being otherwise understood that such a number of bits and levels is purely exemplary and in no way limiting.

As exemplified in Figure 7, a conventional flash ADC 564 comprises:
a plurality of comparators 5641, 5642, ..., 5647, each comparator (e.g., a first comparator 5641) in the plurality of comparators 5641, 5642, ..., 5647 having a first input node (e.g., input node I₁) configured to receive a respective input signal (e.g., I₁) and a second input node coupled to a reference voltage line V_{REF}, -V_{REF} via a respective set of resistive elements R (represented as blocks in Figure 7), each resistive element in the set of resistive elements R having a same resistance, each comparator in the plurality of comparators 5641, 5642, ..., 5647 configured to produce a respective bit in a set of bits B₁, B₂,..., B₇ making up the digital word W output by the flash ADC 564.

For instance, comparators in the plurality of comparators 5641, 5642, ..., 5647 assert each bit in the set of bits B₁, B₂, ..., B₇:
having a first logic value (e.g., "high" or "1") in response to the respective comparator in the plurality of comparators 5641, 5642, ..., 5647 detecting that the respective input signal has a level higher than the reference threshold, e.g., V_{REF}/R, and
having a second logic value (e.g., "low" or "0") in response to the respective comparator in the plurality of comparators 5641, 5642, ..., 5647 detecting that the respective input signal has a level lower than or equal to the reference threshold.

As appreciable to those of skill in the art, the reference voltage line V_{REF}, - V_{REF} is a stable reference voltage line, e.g., provided by a precision voltage regulator as part of the converter circuit (not visible in Figures 7, 7A).

As appreciable to those of skill in the art, the comparators of the set of comparators 5641, 5642, ..., 5647 may have their output nodes B1, B2, ..., B7 coupled to an encoder (not visible in Figures 7, 7A) configured to provide the digital signal W to a digital loop filter (not visible in Figures 7, 7A).

As exemplified in Figure 7A, an alternative flash ADC 564 comprises the plurality of comparators 5641, 5642, ..., 5647 having their second input nodes coupled to the reference voltage line V_{REF}, -V_{REF} via respective resistive elements whose value of resistance may vary.

Specifically, as exemplified in Figure 7A:
resistive elements coupled to a first comparator 5641 configured to provide the least significant bit B1 have a first value 2R twice the resistance of the "standard" resistive elements R, and
resistive elements coupled to a last comparator 5647 configured to provide the most significant bit B7 have a last value 4R fourfold the resistance of the "standard" resistive elements R.

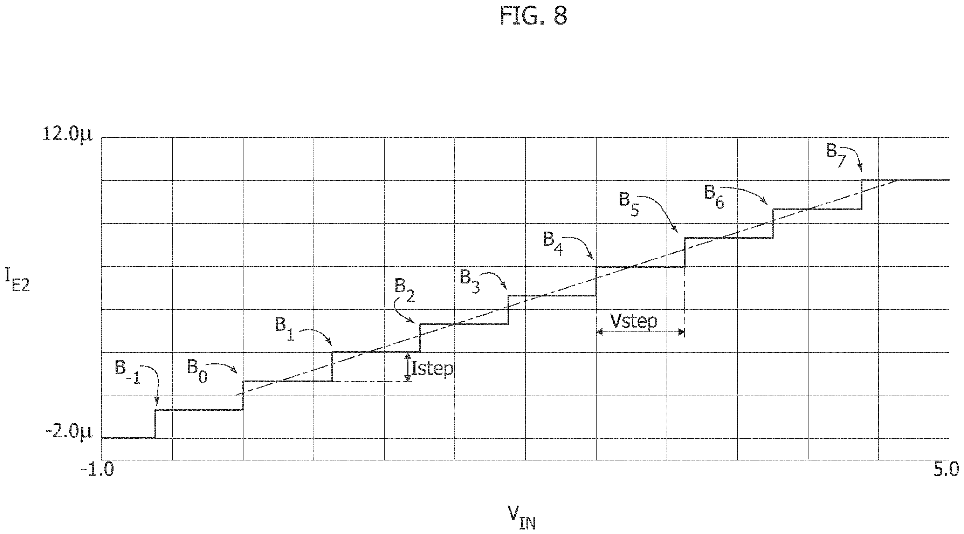

As exemplified in Figure 8, using the conventional arrangement 564 exemplified in Figure 7, the target current I_{E2} is reached by adding up contributions of the various bits B1...B7 output by the comparators in the set of comparators 5641, 5642, ..., 5647, where the contributions are uniform in terms of voltage step Vstep and current step Istep.

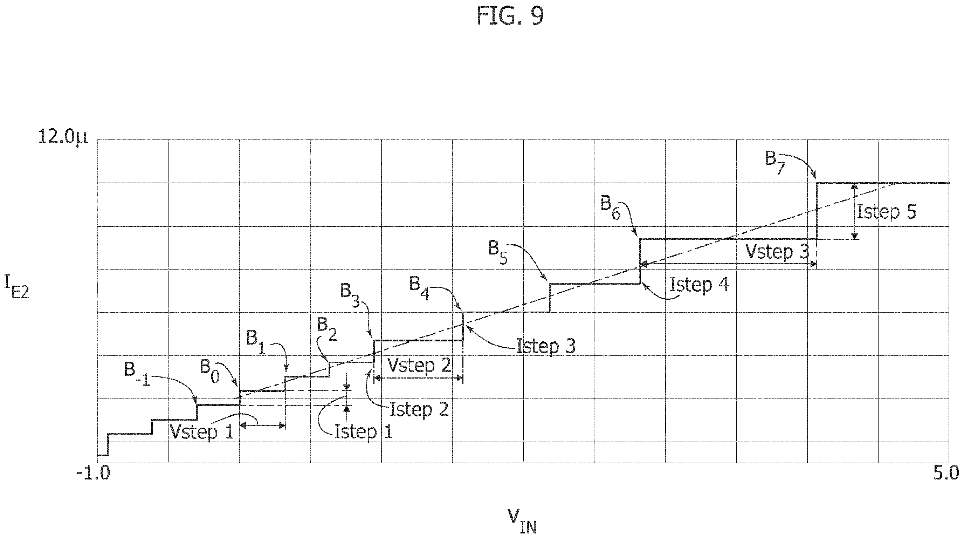

As exemplified in Figure 9, using the alternative arrangement 564' exemplified in Figure 7, the target current I_{E2} is reached by adding up contributions of the various of the various bits B₁...B₇ output by comparators in the set of comparators 5641, 5642, ..., 5647, where the various contributions are distributed in an uneven manner in terms of voltage step Vstep and current step Istep, e.g. with the steps Istep1, Vstep1 of the least significant bits having a reduced size with respect to those of the most significant beats Istep5, Istep4, Istep3, Istep2, Vstep5, Vstep4, Vstep3, Vstep2.

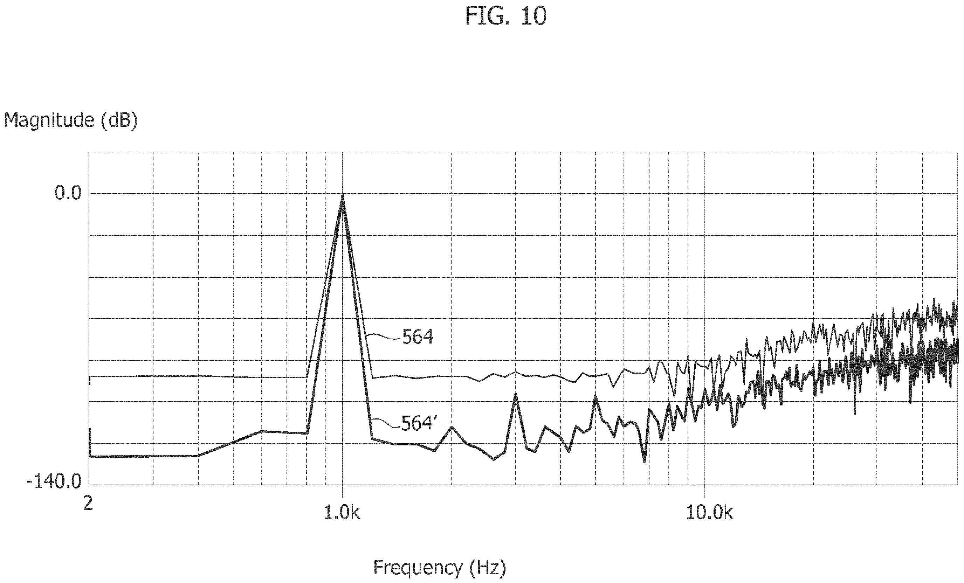

Figure 10 is a diagram showing a comparison of the performance of the system exemplified in Figures 5 and 6 in the frequency domain. As exemplified in Figure 10, using the alternative ADC 564' that varies the threshold levels as a function of the significance of the bits reduces noise in all frequency bands of operation with respect to the use of a conventional flash ADC 564.

As exemplified herein, applying flash ADC conversion 564' comprises:
performing a comparison 5641, 5642, 5647 of the integrated version of the error current signal and a plurality of different threshold levels R, 2R, 4R, producing the bits in the plurality of bits B₁, B₂, B₇ of the digital word W based on the result of the comparison 5641, 5642, 5647.

As exemplified herein, wherein the flash ADC converter (564') of the audio amplifier comprises:
a plurality of comparators 5641, 5642, 5647 configured to perform a comparison of the integrated version of the error current signal with a plurality of different threshold levels R, 2R, 4R, producing the bits in the plurality of bits B₁, B₂, B₇ of the digital word W based on the result of the comparison.

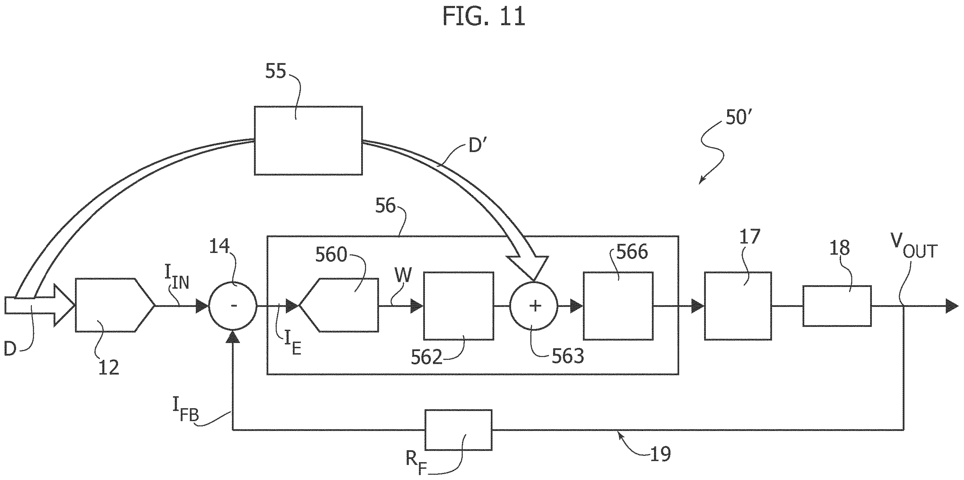

As exemplified in Figure 11, an alternative scenario 50' of the system 50 comprises:
a digital feedforward circuit block 55 configured to receive the digital input signal D and to apply a phase and amplitude correction thereto, producing a compensating digital signal D' as a result, and
an adder circuit block 565 between the digital filter circuit 562 and the digital PWM stage 566, the adder circuit block 565 coupled to the digital feedforward circuit block 55 and configured to receive the compensating digital signal D' therefrom to superimpose it to the digital signal provided by the digital filter circuit 562.

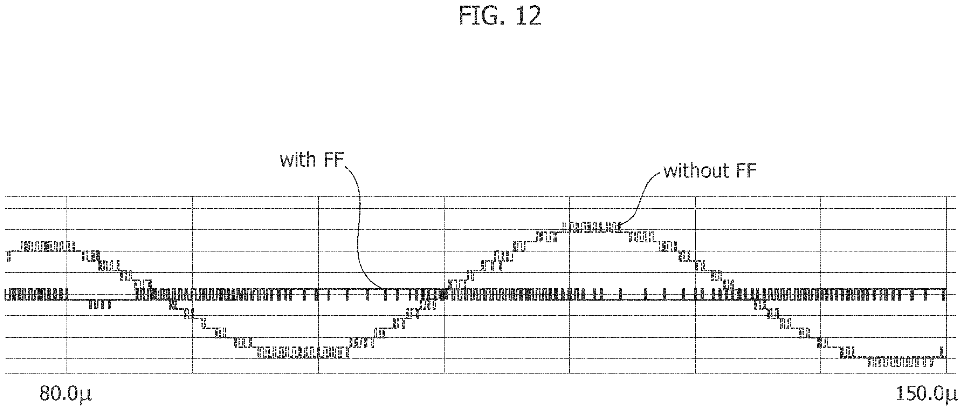

As exemplified in Figure 12, in case the range of values of the gain of the digital filter circuit 562, e.g., in the audio frequency range above 10kHz, cannot reach a suitable maximum value due to stability constraints, the digital signal W output by the ADC 560 may have a spurious signal component, e.g., sinusoidal, at the frequency of the signal superimposed thereon. As exemplified in Figures 11 and 12, such a spurious component may be compensated thanks to the digital feedforward (briefly, FF) circuit block 55 of the arrangement 50' exemplified in Figure 11.

As exemplified herein, the method comprises:
applying phase and magnitude correction 55 to the digital input signal, producing a compensating digital signal D' as a result;
adding 563 the compensating digital signal to the filtered digital error signal, and
producing the pulse-width-modulated, PWM, signal based on the sum of the filtered digital error signal and the compensating digital signal.

As exemplified herein, the audio amplifier comprises:
a feedforward circuit 55 coupled to the input node to receive the digital (audio) input signal, the feedforward circuit configured to apply phase and magnitude correction to the digital input signal, producing a compensating digital signal D' as a result;
an adder circuit 563 coupled to the digital filter circuit to receive the filtered digital error signal D_{C}, the adder circuit configured to add the compensating digital signal to the filtered digital error signal Dc, providing the resulting sum signal to the PWM generator circuit 566,
wherein the PWM generator circuit is configured to drive said switching converter circuit with the PWM signal produced based on the sum of the filtered digital error signal and the compensating digital signal.

It will be otherwise understood that the various individual implementing options exemplified throughout the figures accompanying this description are not necessarily intended to be adopted in the same combinations exemplified in the figures. One or more embodiments may thus adopt these (otherwise non-mandatory) options individually and/or in different combinations with respect to the combination exemplified in the accompanying figures.

Without prejudice to the underlying principles, the details and embodiments may vary, even significantly, with respect to what has been described by way of example only, without departing from the extent of protection. The extent of protection is defined by the annexed claims.

## Claims

1. A method, comprising:
receiving a digital audio input signal (D),
applying signal processing (12, 14, 56, 17) to the digital audio input signal (D) received and providing an analog audio output signal (V_{OUT}) based on the digital audio input signal (D) via a switching converter circuit (17) driven by a pulse-width-modulated, PWM, signal (DRV),
sensing (19, R_{FB}) the analog audio output signal (V_{OUT}) and providing an analog feedback signal (I_{FB}) indicative of the sensed analog audio output signal (V_{OUT}),
wherein applying signal processing (12, 14, 56, 17) to the digital audio input signal (D) comprises:
applying digital-to-analog conversion, DAC (12) to the digital audio input signal (D), producing an analog replica of the digital input signal (I_{IN}) as a result;
producing (14) an analog error signal (I_{E}) indicative of a difference between the analog replica of the digital input signal (I_{IN}) and the analog feedback signal (I_{FB});
applying analog-to-digital conversion, ADC (560) to the analog error signal (I_{E}), producing a digital error signal (W) as a result;
applying digital filtering (562) to the digital error signal (W), producing a filtered digital error signal (Dc) as a result; and
driving said switching converter circuit (17) with the PWM signal (DRV) produced based on the filtered digital error signal (D_{C}).

2. The method of claim 1, wherein:
the analog output signal (V_{OUT}) comprises an output voltage signal;
the analog feedback signal (I_{FB}) indicative of the sensed analog voltage signal (V_{OUT}) comprises a feedback current signal (I_{FB}) obtained as a ratio of the sensed analog voltage signal and a feedback resistive element (R_{FB});
applying digital-to-analog, DAC conversion (12) to the digital input signal (D) comprises converting the digital input signal (D) to an analog input current signal (I_{IN});
the analog error signal (I_{E}) indicative of the difference between the analog input current signal (I_{IN}) and the feedback current signal (I_{FB}) comprises an error current signal (I_{E}); and
the method comprises applying transresistance analog-to-digital, ADC conversion (560) to the error current signal (I_{E}), producing the digital error signal (D_{E}) as a result.

3. The method of claim 2, wherein applying transresistance ADC conversion (560) to the error current signal (I_{E}) comprises applying sigma-delta processing to the error current signal (I_{E}), comprising:
subtracting a second error current signal (I_{E2}) from the error signal (I_{E});
integrating (561) the error current signal (I_{E}), producing an integrated version of the error current signal (I_{E});
applying flash ADC conversion (564; 564') to the integrated version of the error current signal (I_{E}), producing a digital word (W) comprising a plurality of bits (B₁, B₂, B₇) as a result, and
generating (565) the second current signal (I_{E2}) as a function of the digital word (W).

4. The method of claim 3, wherein applying flash ADC conversion (564') comprises:
performing a comparison (5641, 5642, 5647) of the integrated version of the error current signal (I_{E}) and a plurality of different threshold levels (R, 2R, 4R), producing the bits in the plurality of bits (B₁, B₂, B₇) based on the result of the comparison (5641, 5642, 5647).

5. The method of any of the previous claims, comprising:
applying phase and magnitude correction (55) to the digital input signal (D), producing a compensating digital signal (D') as a result;
adding (563) the compensating digital signal (D') to the filtered digital error signal (Dc), and
producing (566) the pulse-width-modulated, PWM, signal (DRV) based on the sum of the filtered digital error signal (D_{C}) and the compensating digital signal (D').

6. The method of any one of the previous claims, comprising providing the output signal (V_{OUT}) to at least one audio speaker (18) and driving the at least one audio speaker (18) to reproduce the audio signal received at the input node.

7. An audio amplifier, comprising:
a digital input node configured to receive a digital audio input signal (D);
a signal processing chain (12, 14, 56, 17) coupled to the digital input node to receive the digital audio input signal (D), the signal processing chain (12, 14, 56, 17) configured to provide an analog audio output signal (V_{OUT}) based on the digital audio input signal (D) via a switching converter circuit (17) driven by a pulse-width-modulated, PWM, signal (DRV);
a sensing circuit branch (19, R_{FB}) coupled to the output node to sense the analog audio output signal (V_{OUT}) and configured to provide an analog feedback signal (I_{FB}) indicative of the sensed analog audio output signal (V_{OUT});
wherein the signal processing chain (12, 14, 56, 17) comprises:
a digital-to-analog, DAC converter circuit (12) configured to apply digital-to-analog, DAC conversion (12) to the digital audio input signal (D), producing an analog replica of the digital input signal (I_{IN}) as a result;
a superposition node (14) coupled to the sensing circuit branch (19, RF) to receive the analog feedback signal (I_{FB}) and coupled to the DAC converter circuit (12) to receive the analog replica of the digital input signal (I_{IN}), the superposition node (14) configured to produce (14) an analog error signal (I_{E}) indicative of a difference between the analog replica of the digital input signal (I_{IN}) and the analog feedback signal (I_{FB});
an analog-to-digital converter, ADC circuit (560) coupled to the superposition node (14) to receive the analog error signal (I_{E}) therefrom and configured to apply analog-to-digital conversion, ADC (560) to the analog error signal (I_{E}), producing a digital error signal (W) as a result;
a digital filter circuit (562) coupled to the ADC circuit (560) to receive the digital error signal (W) and configured to apply digital filtering (562) to the digital error signal (W), producing a filtered digital error signal (Dc) as a result, and
a pulse-width-modulated, PWM, generator circuit (566) coupled to the digital filter circuit (562) to receive the filtered digital error signal (Dc), the PWM generator circuit (566) configured to drive said switching converter circuit (17) with the PWM signal (DRV) produced based on the filtered digital error signal (Dc).

8. The audio amplifier of claim 6, wherein:
the analog output signal (V_{OUT}) at the output node comprises an output voltage signal (V_{OUT});
the analog feedback signal (I_{FB}) indicative of the sensed analog voltage signal (V_{OUT}) comprises a feedback current signal (I_{FB}) obtained as a ratio of the sensed analog voltage signal (V_{OUT}) and a feedback resistive element (R_{FB});
the digital-to-analog converter circuit (12) is configured to apply digital-to-analog conversion (12) to the digital input signal (D), converting the digital input signal (D) to an input current signal (I_{IN});
the analog error signal (I_{E}) indicative of the difference between the input current signal (I_{IN}) and the feedback signal (I_{FB}) comprises an error current signal (I_{E}); and
the ADC circuit (560) is configured to apply transresistance analog-to-digital conversion (560) to the error current signal (I_{E}), producing the digital error signal (D_{E}) as a result.

9. The audio amplifier of claim 7 or claim 8, wherein the ADC circuit (560) configured to apply transresistance analog-to-digital conversion (560) to the error current signal (I_{E}) comprises sigma-delta processing circuitry, comprising:
a subtracting node (E) coupled to the superposition node (14) to receive the error signal (I_{E}), the subtracting node (E) configured to subtract a second error current signal (I_{E2}) from the error signal (I_{E});
an integrator circuit (561) coupled to the subtracting node (E), the integrator circuit (561) configured to integrate (561) the error current signal (I_{E}), producing an integrated version of the error current signal (I_{E});
a flash ADC converter (564; 564') coupled to the integrator circuit (561) to receive the integrated version of the error current signal (I_{E}), the flash ADC converter (564; 564') configured to apply flash ADC conversion (564; 564') to the integrated version of the error current signal (I_{E}), producing a digital word (W) comprising a plurality of bits (B₁, B₂, B₇) as a result.

10. The audio amplifier of any of claims 7 to 9, wherein the flash ADC converter (564') comprises a plurality of comparators (5641, 5642, 5647) configured to perform a comparison (5641, 5642, 5647) of the integrated version of the error current signal (I_{E}) with a plurality of different threshold levels (R, 2R, 4R), producing the bits in the plurality of bits (B₁, B₂, B₇) based on the result of the comparison (5641, 5642, 5647).

11. The audio amplifier of any of claims 7 to 10, comprising:
a feedforward circuit (55) coupled to the input node to receive the digital audio input signal (D), the feedforward circuit (55) configured to apply phase and magnitude correction (55) to the digital input signal (D), producing a compensating digital signal (D') as a result;
an adder circuit (563) coupled to the digital filter circuit (562) to receive the filtered digital error signal (Dc), the adder circuit (563) configured to add the compensating digital signal (D') to the filtered digital error signal (Dc), providing the resulting sum signal to the PWM generator circuit (566),
wherein the PWM generator circuit (566) is configured to drive said switching converter circuit (17) with the PWM signal (DRV) produced based on the sum of the filtered digital error signal (D_{C}) and the compensating digital signal (D').

12. The audio amplifier of any one of claims 7 to 11, coupled to at least one audio speaker (18) to provide thereto the output signal (V_{OUT}), the audio amplifier configured to drive the at least one audio speaker (18) to reproduce the audio signal received at the input node.
